# FASCICULE DE BREVET EUROPEEN

(11) **EP 2 475 611 B1**
(45) Date de publication et mention de la délivrance du brevet: **03.07.2013**
(21) Numéro de dépôt: 10770542.8
(22) Date de dépôt: 08.09.2010
(51) Int. Cl.: B81C 1/00, B82B 3/00

(54) **PROCÉDÉ DE PRÉPARATION D'UNE SURFACE STRUCTURÉE FONCTIONNELLE ET SURFACE OBTENUE PAR CE PROCÉDÉ**
VERFAHREN ZUR HERSTELLUNG EINER FUNKTIONALEN STRUKTURIERTEN OBERFLÄCHE UND NACH DEM VERFAHREN ERHALTENE OBERFLÄCHE
Method for preparing a functional structured surface and surface obtained by said method

(30) Priorité: 11.09.2009 FR 0956277
(43) Date de publication de la demande: 18.07.2012
(73) Titulaire: Commissariat à l'Énergie Atomique et aux Énergies Alternatives, 75015 Paris (FR)
(72) Inventeur: DOURDAIN, Sandrine, F-30330 Tresques (FR); TERECH, Pierre, F-38500 Saint-Cassien (FR)
(74) Mandataire: Kurtz, Laurent Charles Edmond
(86) Numéro de dépôt international: PCT/FR2010/051874
(87) Numéro de publication internationale: WO 2011/030060

(56) Documents cités:
- WO-A1-2006/132294
- WO-A2-98/34723
- WO-A2-2008/054411
- FR-A1- 2 927 169
- US-A1- 2004 106 178
- STEIN A. ET AL.: "Hybrid inorganic-organic mesoporous silicates-Nanoscopic reactors coming of age", ADVANCED MATERIALS, vol. 12, no. 19, 2 octobre 2000 (2000-10-02), pages 1403-1419, XP002581603,
- DONGYUAN Z. ET AL.: "Synthesis of continuous mesoporous silica thin films with three-dimensional accessible pore structures", CHEMICAL COMMUNICATION, 1998, pages 2499-2500, XP002581604,

## Description

La présente invention porte sur un procédé de préparation d'une surface structurée fonctionnelle, et une surface obtenue par le procédé.

On cherche actuellement à mettre au point des objets fonctionnels de dimensions allant de l'échelle moléculaire à l'échelle nanoscopique en grande quantité et à moindre coût. Ces objets peuvent être produits par voie chimique ou par voie physique.

Cependant, pour être pleinement exploitables ces nano-objets (nanoparticules, nanofils, nanotubes par exemple) doivent être manipulables et accessibles. Il est notamment nécessaire de connaître leur localisation ou leur orientation, les uns vis-à-vis des autres, et par rapport à un système de coordonnées macroscopiques.

Que ce soit pour des applications en biologie, électronique moléculaire ou en nano-magnétisme, le positionnement contrôlé de nano-objets sur une surface est donc un enjeu technologique majeur. Différentes technologies ont été envisagées et certaines mises en oeuvre ont été décrites.

Une pointe AFM (microscope à force atomique) peut par exemple assurer un dépôt localisé ou un greffage spécifique de particules. Cette approche n'est cependant applicable que pour un nombre limité de particules à positionner en surface.

A plus grande échelle, les surfaces nanostructurées par lithographie par faisceau d'électrons, par faisceau d'ions focalisé ou par lithographie nano imprint (thermoplastique, par photoactivation ou autre) peuvent être utilisées pour localiser des particules, présentes en solution ou en phase gazeuse. Le document WO 2008/012923 (Harvard) présente dans ce cadre une méthode de fabrication d'une nanostructure basée sur l'encapsulation d'un matériau métallique, organique ou semi-conducteur sur une surface indentée suivie de la coupe du matériau d'encapsulation réalisée en sorte de créer une nanostructure isolée en matériau d'intérêt.

L'auto-assemblage de molécules amphiphiles permet par ailleurs de générer des surfaces structurées macroscopiques présentant des motifs plus petits (de 2 à 100 nm) et organisés. Des surfaces organiques structurées sont notamment formées par recuit de tensioactifs (par exemple Aisson et al, Surface Science 2007, 601, 2611). Les technique proposées ne permettent malheureusement pas de fonctionnalisation sélective des motifs d'où une difficulté de contrôler le positionnement de nano-objets sur ces surfaces.

L'encapsulation de nanoparticules directement dans des micelles de tensioactifs permet également de générer des réseaux organisés de particules sur des grandes surfaces. Le document WO 2008/125172 (Max Planck Gesellschaft et Université d'Heidelberg) décrit ainsi une méthode impliquant l'immersion d'un substrat dans une solution de copolymère multibloc chargée d'une espèce métallique, l'extraction progressive du substrat hors de la solution puis une étape de réduction ou oxydation du composé métallique en sorte de former des nanoparticules.

L'auto-organisation de nanoparticules sur une surface obtenue grâce aux interactions inter-particules est aussi utilisée sur des grandes surfaces en s'aidant de substrats pré-structurés par les méthodes lithographiques. Le document WO 2006/051186 (CEA) décrit à ce sujet un procédé comprenant un dépôt de particules sur un substrat avec une auto-organisation des particules et une interaction modulée entre le substrat et les particules. Le document US 7164209 (Nanosys Inc.) décrit, quant à lui, l'utilisation d'un masque combiné à un alignement par l'action d'un flux gazeux ou des nanoparticules à disposer.

Ces dernières méthodes n'offrent cependant qu'une barrière de potentiel limitée entre les particules ce qui conduit à la formation d'agglomérats notamment sous l'action extérieure d'un recuit.

Par ailleurs, on connaît des couches inorganiques mésoporeuses, utilisant l'organisation de phases lyotropes. Le document US 6326326 (Battelle Memorial Institute) décrit une méthode impliquant l'hydratation d'un matériau mésoporeux, un mélange du matériau avec des précurseurs de molécules fonctionnelles, l'agitation en vue de provoquer la perméation des précurseurs à travers les pores et un chauffage. On précise à ce sujet que la catégorie des mésopores est définie par l'IUPAC comme englobant les pores de largeur comprise entre 2 et 50 nm, les pores plus petits étant qualifiés de micropores, et les pores plus gros de macropores (voir par exemple Pure & Appl. Chem., Vol. 57, No. 4, pp. 603-619, 1985.).

On connaît de plus du document « First Direct Synthesis of highlyordered bifunctionalized mesoporous silica thin films » de Mehdi et al., J. Nanosciences and Nanotechnology 6, 377, 2006, une synthèse de films d'alcoxydes de silicium ordonnés et mésoporeux fonctionnalisés, basée sur un auto-assemblage induit par évaporation. On connaît également du document « Ordered large-pore mesoporous silica film with lm3m symmetry synthesizedin ternary copolymer-butanol-water system » de Fang et al., Materials Letters, 60, 5, 2006, 581-584, une préparation d'un film de silice mésoporeuse à pores élargis.

Néanmoins, la surface extérieure de ces couches mésoporeuses ne présente généralement pas de structuration, ni de fonctionnalisation sélective et n'est pas utilisable pour la disposition contrôlée de nano-objets.

Dans un autre ordre d'idée, on connaît également du document « Grating induced micelle alignment of mesostructured silica films », Applied Physics Letters, 91, 2, 2007, une étude du comportement face à une gravure chimique d'un film de silice mésostructurée. On connaît également du document « On the etching of silica and mesoporous silica films determined by X-ray reflectivity and atomic force microscopy », Thin solid films, 517, 9, 3028, 2009, une étude de l'effet de l'attaque de films de silice mésoporeuse par une solution de soude, suggérant l'existence de plusieurs étapes avant un effondrement final du film.

Les méthodes utilisées dans ces études ne permettent pas un enlèvement de matière contrôlé et détruisent rapidement la structure poreuse de la couche.

On connaît également du document « Surface Nanopatterning by Organic/Inorganic Self-Assembly and Selective Local Functionalization », Small, 2006, 2, 587, une étude du mécanisme de formation de cratères obtenus par traitement thermique d'une couche d'oxyde de titane structurée. L'étape de calcination est destructrice pour les groupements chimiques fragiles éventuellement présents et ne permet pas d'envisager un emploi ultérieur de la surface extérieure.

Le document FR 2 927 169 A1 décrit un procédé de préparation d'une surface structurée fonctionnelle appliquée à un matériau comprenant au moins un pore, procédé selon lequel le pore, dont au moins une extrémité est débouchante, est placé dans un compartiment contenant des entités électroactivables dont l'activation via un signal électrique appliqué entre deux électrodes permet de fonctionnaliser la surface interne dudit pore par création de groupes chimiques d'accrochage.

La présente invention résout ces problèmes.

Pour résoudre les problèmes évoqués ci-dessus, l'invention propose un procédé de préparation d'une surface structurée comprenant une étape d'enlèvement de matière appliquée à un matériau comprenant au moins un pore enterré. L'enlèvement de matière est effectué par une technique d'abrasion anisotrope en sorte de rendre accessible une partie de la surface interne du pore, non affectée par l'enlèvement de matière. Cela peut être réalisé en adaptant les conditions de durée, intensité et direction de l'enlèvement de matière. La surface interne du pore comporte des groupes chimiques d'accrochage.

On précise que de manière générale, les groupes chimiques d'accrochage considérés peuvent être présentés affleurant ou dépassant de la surface interne du pore. Ils peuvent être reliés à la masse du matériau par un bras espaceur, qui peut être court ou long, branché ou linéaire. Typiquement un bras espaceur correspond à une structure éloignant le groupe chimique d'accrochage du matériau et permet d'éviter les effets d'encombrement stérique. La structure du groupe espaceur est peu réactive avec son environnement, elle peut par exemple correspondre à une chaine de type alkyle ou cycloalkyle.

L'enlèvement de matière peut être effectué par un traitement physique, chimique ou physico-chimique d'abrasion, de préférence avec un taux d'abrasion de l'ordre de quelques nm par minute (moins de 5 nm.s⁻¹, voire moins de 1 nm.s⁻¹), et une horizontalité inférieure à 10 %, voire 5 %, ou 2,5 % (définie entre l'écart entre le point le plus haut et le point le plus bas de la surface, rapporté à l'épaisseur éliminée)

L'abrasion peut être réalisée à l'aide d'un liquide sous pression comme de l'eau, un solvant organique ou de l'azote, éventuellement en association avec des ultra-sons, ou un gaz comme de l'air comprimé.

L'abrasion peut être réalisée avec un abrasif - c'est-à-dire un produit se présentant sous la forme de particules solides finement divisées - seul ou dans un vecteur liquide (comme de l'eau) ou gazeux (comme de l'air comprimé). Cet abrasif peut être inorganique ou organique.

L'abrasion peut aussi être réalisée avec des particules d'une entité chimique qui, dans des conditions normales de température et de pression (25°C, 1 atmosphère), est plus stable sous forme gazeuse que sous d'autres formes, par exemple de la glace carbonique à l'état solide ou à l'état supercritique.

Elle peut encore être effectuée à l'aide d'un rayonnement électromagnétique du type faisceau laser ou micro-ondes, qui a pour effet d'induire un changement des paramètres physiques de la surface à traiter, comme sa température, ce qui peut conduire à la vaporisation et à la dispersion de cette surface.

Enfin l'abrasion peut être mécanique, induite par une surface solide d'un instrument effectuant une opération de polissage. Elle peut aussi être effectuée par voie chimique en solution, ou par chimie sèche, ou par recuit.

L'utilisation d'un pore et d'une abrasion adaptée permet d'obtenir une surface nanostructurée tout en conservant intacts des groupements d'accrochage qui sont ensuite accessibles. L'utilisation d'une technique d'abrasion anisotrope, c'est-à-dire dans laquelle le milieu environnant le matériau comprenant au moins un pore subit des mouvements non isotropes ou orientés (présence par exemple d'un flux) est avantageuse dans ce contexte.

La partie du pore non affectée et rendue accessible est par la suite qualifiée d'alvéole. Elle peut avoir la géométrie d'une fraction de sphère.

Par rendre accessible la surface interne du pore ou de l'alvéole, on entend augmenter l'angle solide à travers lequel un objet peut atteindre la surface en se déplaçant en ligne droite depuis l'extérieur du matériau sans rencontrer d'obstacle.

L'abrasion crée une ouverture dans le pore, à travers laquelle l'alvéole est accessible depuis l'extérieur du matériau. L'ensemble du processus de traitement du matériau est fait en sorte de libérer une surface, qualifiée de surface structurée car elle comprend au moins l'alvéole. Cette surface peut être plane, ou posséder une courbure.

L'invention s'applique aux domaines industriels de l'électronique moléculaire, de la nano électronique, du magnétisme, de la nano-optique, de la biologie (notamment les puces à ADN), et de la chimie (catalyse, capteurs chimiques).

Les groupements d'accrochage, sont des fonctions chimiques qui peuvent être utilisés pour ancrer spécifiquement des nano-objets, permettant ainsi de les positionner dans une alvéole, voire de les organiser si plusieurs alvéoles forment un réseau organisé. Les groupements d'accrochage présentent une affinité physico-chimique pour des nano-objets.

Généralement on considère qu'il existe une affinité entre un groupement d'accrochage et un nano-objet lorsqu'il est possible de corréler la durée du contact entre une suspension de nano-objet et une surface comportant des groupements d'accrochage à une diminution de la concentration en nano-objets au sein de la suspension, une valeur plateau étant généralement atteinte, indépendamment d'une éventuelle démixtion des nano-objets dans la suspension.

Il est ainsi possible de déterminer des couples nano-objets/groupement d'accrochage entre lesquels il existe une affinité. L'affinité est généralement due à des interactions de type faible ou fort qui se développent entre la surface des nano-objets et les groupements d'accrochage. Parmi les interactions de type faible, on peut notamment citer les liaisons hydrogène, les liaisons de type ioniques, les liaisons de complexation, les interactions pi (« pi stacking »), les liaisons de Van der Waals, les liaisons hydrophobes (ou liaisons apolaires type surfactant) ; parmi les liaisons fortes on peut citer les liaisons covalentes qui peuvent se former spontanément.

Parmi les fonctions chimiques utilisables dans ce cadre on peut citer notamment les fonctions amine, nitrile, thiol ou un les fonctions comportant des phosphores.

Un nano-objet est un objet de taille nanométrique, dont la plus grande dimension est inférieure à 1 µm et typiquement inférieure à 100 ou 25 nm. Il peut notamment s'agir d'une nanoparticule, d'un nanocristal, d'un nanofil ou d'un nanotube ou encore d'une nanocolonne. Un tel nano-objet peut être organique ou inorganique et être présenté en solution ou en phase gazeuse. Il peut comporter en surface un ou des ligands organiques.

Les nano-objets utilisés dans le cadre de l'invention ont avantageusement une taille inférieure à la taille moyenne de l'ouverture pratiquée dans le pore au cours de l'étape d'abrasion, ce qui leur permet d'y pénétrer.

Selon une caractéristique avantageuse, le procédé comprend donc de plus une étape de positionnement de nano-objets sur la surface structurée.

Ainsi on obtient une surface présentant des nano-objets positionnés dans la structure en relief de la surface, par exemple sur la surface interne du pore rendue accessible à la surface (l'alvéole).

Cela offre l'avantage d'une barrière de potentiel importante pour le positionnement des nano-objets.

Selon une caractéristique avantageuse, le positionnement comprend un dépôt par imprégnation, par exemple en solution.

Selon une caractéristique avantageuse, le matériau traité contient avant le traitement une couche de pores enterrée, et l'enlèvement de matière est effectué en sorte de rendre accessible une partie des surfaces internes respectives des pores de la couche. Celle-ci peut être plane, mais aussi avoir une courbure.

Eventuellement, la couche contient un réseau ordonné de pores. On obtient alors une surface structurée comprenant un réseau ordonné d'alvéoles. En disposant des nano-objets dans ce réseau d'alvéoles, on obtient un positionnement contrôlé de ces nano-objets, qui sont accessibles et manipulables, puisque disposés dans les alvéoles dont la disposition est connue.

Selon une caractéristique avantageuse, la matière enlevée au cours de l'étape d'abrasion est une couche continue à l'opposé, par rapport au plan de la couche de pores, d'une zone sous-jacente d'intérêt fonctionnel particulier rendue accessible par ledit enlèvement de matière.

Ainsi, en partant d'un matériau présentant une organisation volumique, on obtient une surface structurée en relief avec des caractéristiques de structure contrôlées, et offrant une accessibilité à une zone d'intérêt sous-jacente dans le matériau. Suivant les applications, la zone d'intérêt auquel une accessibilité nouvelle est ainsi offerte, est une zone du matériau traité, ou une zone d'un support sur lequel le matériau traité est posé ou a été synthétisé.

Selon une caractéristique avantageuse, l'enlèvement de matière est effectué par abrasion par un faisceau, par exemple d'ions, appliqué en incidence contrôlée. L'incidence est préférentiellement comprise entre 0 et 10°, ou préférentiellement entre 0 et 5, voire entre 0 et 2° par rapport à une surface de référence du matériau, par exemple parallèle à la couche de pores, si celle-ci est plane. Pour ces faibles valeurs d'angle, l'incidence est qualifiée de rasante.

En enlevant de la matière autour des pores, l'abrasion par faisceau, par exemple par faisceau d'ions, génère des surfaces nanostructurées sur des dimensions macroscopiques. Cette technique d'abrasion permet de plus de préserver les fonctions chimiques spécifiquement présentes à la surface des pores.

L'abrasion par faisceau d'ions peut être appliquée avec un faisceau d'argon, d'oxygène ou d'un autre type de gaz permettant des taux d'abrasion adaptés.

Selon une caractéristique avantageuse, le matériau comprenant au moins un pore est préalablement formé par évaporation d'un solvant après un dépôt sur un substrat ou support, par exemple par enduction centrifuge (« *spin coating* ») ou par trempage (« *dip coating* »), d'une solution liquide contenant un précurseur dudit matériau comprenant au moins un pore, le précurseur ayant entre temps subi une réaction de condensation.

Le processus de préparation du matériau peut ainsi impliquer préalablement un phénomène de transformation du matériau de la solution liquide en matériau solide au cours de laquelle la matière en réaction subit des réactions physico-chimiques, impliquant par exemple des changements de phase ou un phénomène de condensation sol-gel, qui conduisent à l'acquisition par la matière d'une structure solide.

Par exemple, le matériau contient une pluralité de mésopores, et est qualifié de matériau mésoporeux. Selon une caractéristique avantageuse, le solvant comprend pour cela un ou plusieurs tensioactifs. Une étape de réaction de la solution de précurseur en présence du ou des tensioactifs constitue alors une étape de structuration qui détermine la géométrie du matériau mésoporeux.

Grâce au tensioactif choisi on obtient une géométrie particulière, connue et contrôlée, avec des distances entre pores adaptées, et une taille de pores adaptée.

Alternativement, la structuration du matériau peut également être induite électro-chimiquement. Par exemple, un potentiel appliqué à une électrode immergée dans une solution contenant des tensioactifs et le sol de silice, génère des ions hydroxyles permettant de catalyser la réaction de polycondensation des précurseurs de silice autour des tensioactifs auto-assemblés. Le potentiel déclenche ainsi la croissance d'une couche mésostructurée directement sur la surface de l'électrode.

Selon une caractéristique avantageuse, la solution liquide à partir de laquelle le matériau est synthétisé contient des molécules capables de réagir avec le précurseur pour placer spontanément un groupement d'accrochage à la surface des pores. On parle alors de synthèse directe.

Par exemple, ces molécules comportent un groupement de fixation dans le matériau, capable de condenser avec les molécules de précurseur du matériau et une fonction chimique pour liaison ou complexation, capable de servir de groupement d'accrochage pour une nanoparticule sur la surface structurée une fois cette molécule rendue accessible par l'étape d'enlèvement de matière.

Selon une caractéristique avantageuse, le matériau comprend des pores sphériques. Alternativement ou en combinaison, le matériau comprend des pores cylindriques dont la directrice est de préférence sensiblement parallèle à la surface du support sur lequel le matériau est déposé, le cas échéant.

Les motifs sphériques et cylindriques peuvent présenter des diamètres compris entre 2 et 50 nm. La distance entre les motifs peut varier entre 1 et 50 nm, voire entre 2 et 10 nm.

Selon une caractéristique avantageuse, alternative à la synthèse directe mais pouvant aussi lui être combinée le procédé comprend une étape de fonctionnalisation, qui peut être réalisée par imprégnation du matériau à traiter, avant l'étape d'enlèvement de matière, dans une solution contenant au moins une entité comportant un groupe chimique d'accrochage capable de réagir avec les surfaces dudit matériau, ou un précurseur de celui-ci. Comme ladite étape de fonctionnalisation est postérieure à l'étape de structuration (ou synthèse) du matériau, elle est qualifiée de post-synthétique. Elle est notamment postérieure à la formation du ou des pores.

Selon une autre modalité la synthèse directe conduit à un matériau comportant au moins un pore comprenant au moins un précurseur de groupement chimique d'accrochage, qui est converti ultérieurement en le groupement chimique d'accrochage. Le précurseur et le groupement chimique d'accrochage sont typiquement séparés par un nombre restreint d'étapes chimiques, en général pas plus de deux.

Une telle étape permet de préparer le matériau comprenant au moins un pore, avec des fonctions chimiques pouvant servir de groupement d'accrochage dans les pores qui peuvent être différentes de celles qui peuvent être obtenues par synthèse directe. Les groupes d'accrochage obtenus par synthèse directe peuvent aussi être modifiés (en totalité ou partiellement) par une réaction post-synthétique.

Selon une caractéristique avantageuse, l'étape d'enlèvement de matière est effectuée en sorte de rendre accessible à travers l'espace interne du pore une surface d'un support sur lequel le matériau à traiter a été préalablement déposé, ou synthétisé. On peut ainsi profiter des caractéristiques physiques ou chimiques du matériau du support ou pratiquer une transformation du support à travers l'espace interne du pore. Il s'agit là d'un exemple de zone sous-jacente d'intérêt fonctionnel particulier rendue accessible.

Selon une caractéristique avantageuse, le procédé comprend également une étape de fonctionnalisation chimique de la surface du support ainsi rendue accessible. Cette fonctionnalisation peut être pratiquée avant l'étape d'enlèvement de matière, ou après celle-ci.

Selon une autre caractéristique avantageuse, le procédé comprend une étape d'élimination de restes du matériau après une étape de positionnement de nano-objets sur la surface structurée.

Selon une caractéristique avantageuse, le matériau comprenant au moins un pore est choisi parmi les matériaux poreux de la famille des oxydes métalliques comme les oxydes de silicium (SiO₂), titane (TiO₂), zinc (ZnO) ou aluminium (Al₂O₃). Il peut s'agir d'un matériau poreux hybride organique inorganique mésostructuré. Il peut contenir des éléments d'addition ayant un rôle fonctionnel ou structurel, ou des traces résultant du mode de synthèse.

Selon une caractéristique avantageuse, le matériau comprend également une fonctionnalisation dans sa masse (c'est-à-dire des groupes chimiques enterrés au moins capables d'échanger des charges) enterrée à distance des surfaces du matériau, que ce soit les surfaces internes des pores ou les surface externes du matériau. Cette fonctionnalisation peut avoir été obtenue par synthèse directe, et servir pour effectuer des réactions physiques ou physico-chimiques avec des nano-objets positionnés sur la surface structurée.

L'invention concerne aussi la surface obtenue par le procédé présenté.

L'invention va maintenant être décrite en détails en relation avec les figures annexées suivantes.
La figure 1 présente une première étape d'une variante du procédé selon l'invention.
Les figures 2 à 5 présentent des étapes ultérieures du procédé débuté en figure 1.

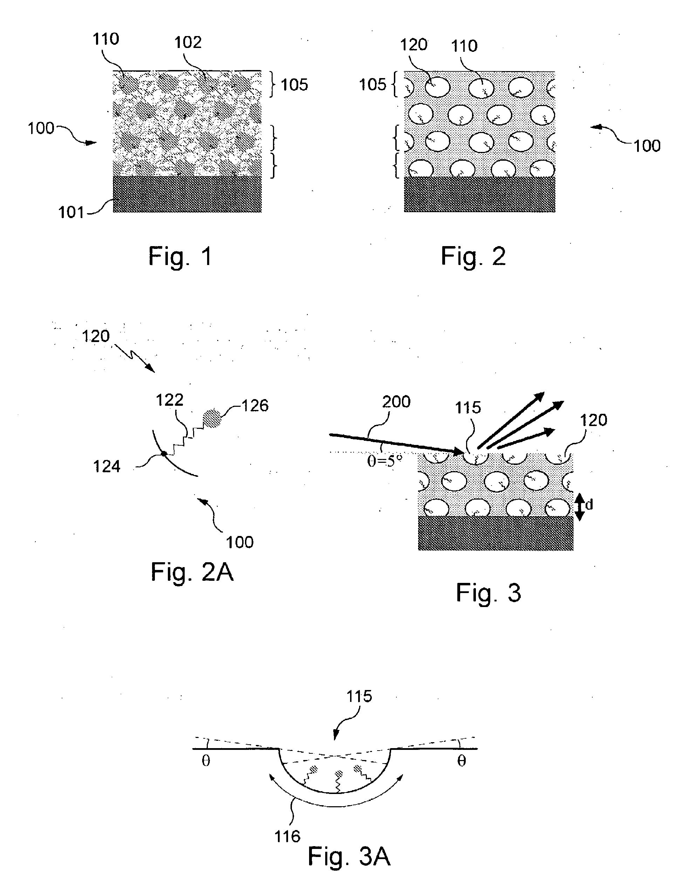

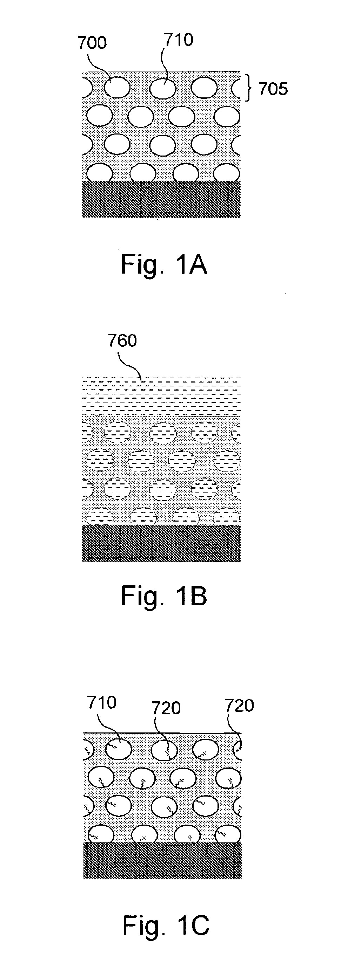

Les figures 1A à 1C présentent une alternative au mode de réalisation de la figure 1.
Les figures 2A et 3A sont des détails relatifs aux figures 2 et 3.

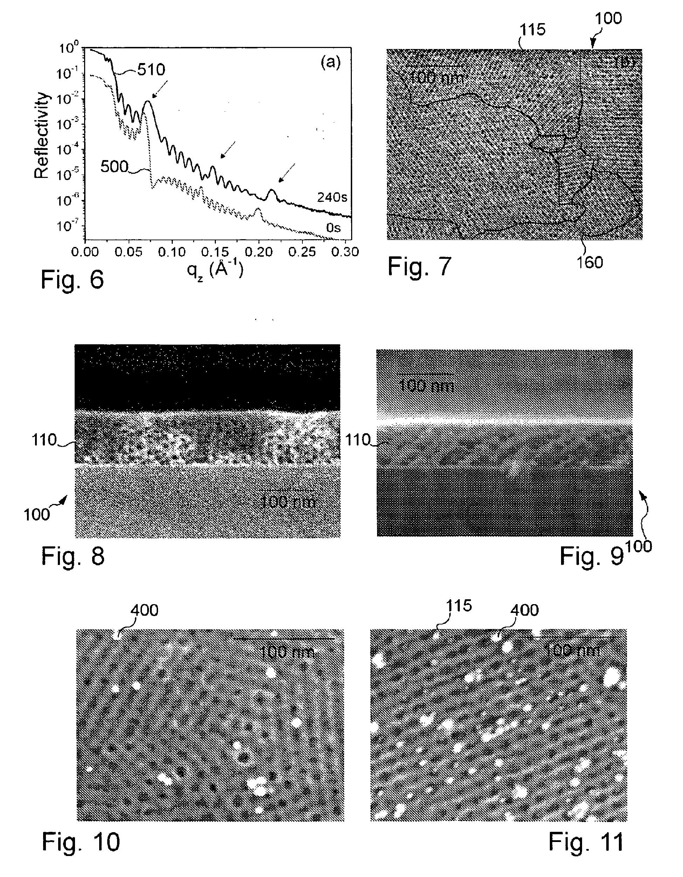

Les figures 6 à 9 présentent différentes caractérisations du matériau utilisé au cours du procédé.

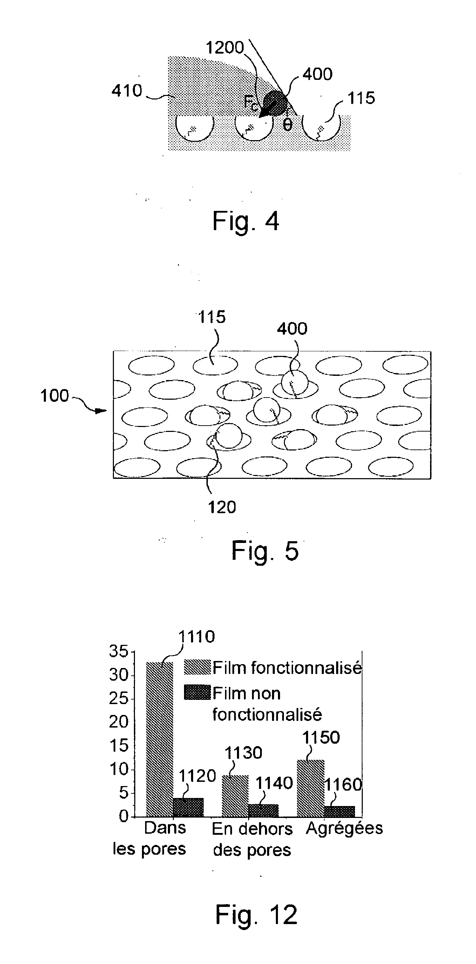

Les figures 11 et 12 présentent différentes caractérisations de la surface produite en fin de procédé, la figure 10 présentant la caractérisation d'une surface témoin; à comparer à la figure 11.

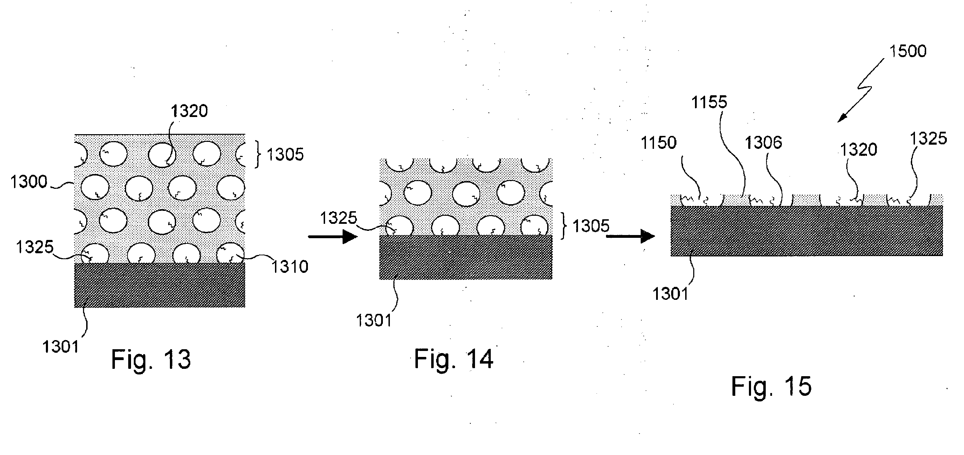

Les figures 13 à 15 présentent un aspect de réalisation d'un mode de réalisation de l'invention.

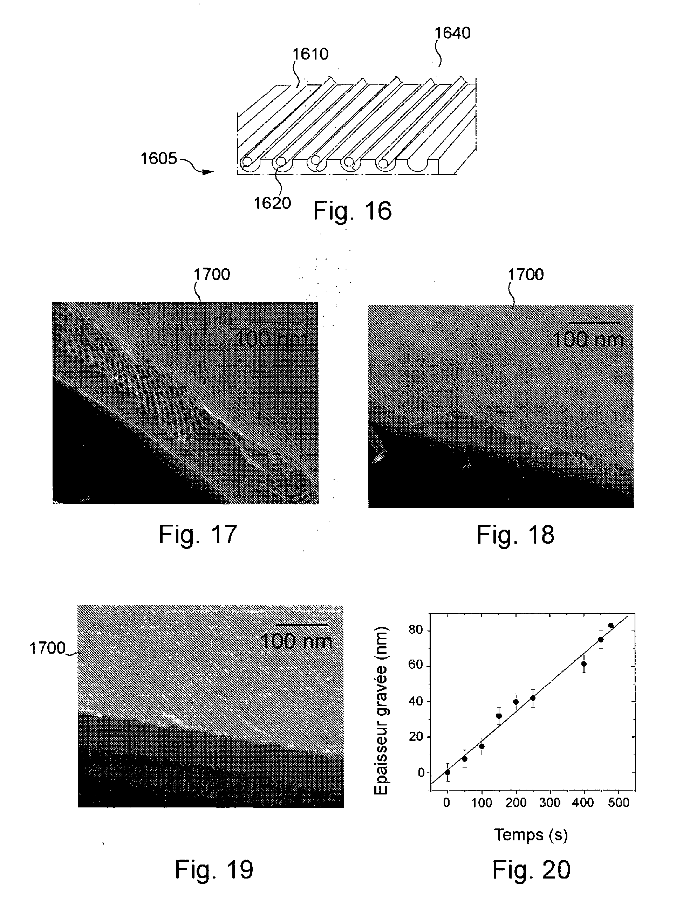

Les figures 16 à 20 présentent un mode de réalisation alternatif de l'invention.

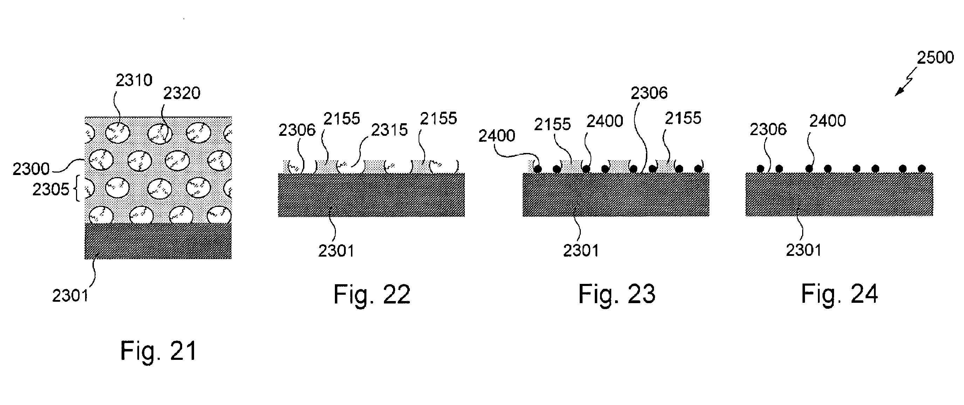

Les figures 21 à 24 présentent un autre mode de réalisation de l'invention.

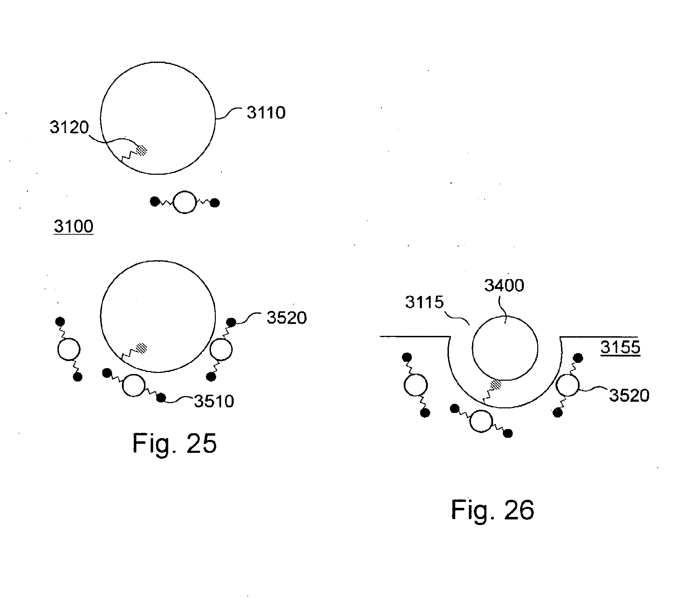

Les figures 25 et 26 présentent aussi un autre mode de réalisation de l'invention.

En relation avec la figure 1, des films minces 100 de silice comportant des arrangements cubiques de pores sphériques sont préparés. Les films 100 de silice mésoporeuse sont synthétisés par trempage (ou « *dip coating* » en anglais) d'un substrat ou support 101 de silicium. Ils sont structurés par le tensioactif F127 102 appartenant à la famille des copolymères triblocs, permettant de former des pores sphériques 110 de diamètre 6 nm. La solution de trempage est préparée en deux étapes. Au cours d'une première étape, le précurseur de silice (le tetraethoxysilane, notés par la suite TEOS) est pré-hydrolysé dans une solution d'eau, d'acide chlorhydrique et d'éthanol, appelée « solution stock ». Le pH de cette solution est de préférence choisi du même ordre de grandeur que le point isoélectrique de la silice (pl égal à 2 et typiquement le pH est donc compris entre 1,2 et 2,6), ce qui permet d'hydrolyser les alkoxydes en ralentissant les mécanismes de condensation. La solution stock est agitée 1 heure.

Une fois hydrolysée la solution est ajoutée à la solution micellaire de F127, constituée du tensioactif dissous dans de l'éthanol.

Le substrat de silicium est trempé dans la solution résultante constituée des fractions stoechiométriques suivantes : 1 TEOS pour 32 EtOH, 5 H₂O, 0,005 HCl et 0,004 F127. La solution finale est agitée 1 h.

Les substrats recouverts de films 1-00 sont ensuite retirés des solutions à une vitesse constante de 14 cm.min⁻¹, l'épaisseur totale du film formé étant alors de l'ordre de 100 nm. Ils sont ensuite séchés à 80°C pendant 4 jours pour améliorer leur tenue mécanique puis rincés à l'éthanol pendant 2 h à 80°C pour extraire les tensioactifs 102 structurants (figure 2). Les pores sphériques 110 sont organisés selon une symétrie cubique lm3m, impliquant la présence de couches 105 de silice mésoporeuse superposées.

Dans le mode de réalisation qui est ici décrit en détails, la fonctionnalisation chimique des pores 110 est faite par synthèse directe. On inclut au moment de l'élaboration des films 100, lors de l'étape de préhydrolyse des précurseurs de silice, au sein de ceux-ci, une fraction de précurseurs fonctionnalisés, ici une molécule 120 à fonction cyanopropyle (cyanopropyle triethoxy-silane). La fraction est préférentiellement de 10 % (rapport stoechiométrique vis-à-vis du TEOS).

On précise ici que ces molécules 120 comportent un bras 122 propyl (mais il pourrait avoir une autre longueur) qui présente une affinité satisfaisante pour le tensioactif, et qui fait fonction d'espaceur entre le groupement triethoxy-silane servant à la fixation dans la masse de silice (le film 100) et la fonction cyano 126 qui peut être utilisée comme groupe d'accrochage. Cela est illustré en figure 2A. Ces molécules condensent avec le TEOS et sont donc insérées de manière covalente au réseau de silice.

L'extraction du tensioactif est effectuée par rinçage par un solvant comme l'éthanol, ce qui permet de préserver au mieux les molécules 120. Celles-ci apparaissent alors spécifiquement greffées à la surface des pores (Figure 2). Par souci de clarté il n'est représenté qu'une molécule 120 par pore et alvéole.

En relation avec la figure 3, une abrasion des couches mésoporeuses 105 est effectuée par application d'un faisceau d'Argon 200 obtenu avec un Plassys MU400 Argon gun COPRA. La source PBS COPRA DN160CF est générée par une onde radiofréquence à 13,56 MHz de puissance maximale 600 W.

Les épaisseurs gravées sont contrôlées par la pression du gaz d'Argon, par la puissance P_{rf} de l'onde radio fréquence générant le faisceau 200, et par le temps de gravure. Dans un mode de réalisation, une pression P(Ar) de 1,2.10⁻⁴ Torr, une puissance de source P_{rf} de 300W, et une durée de 240 s sont utilisées.

Les dimensions du faisceau 200 sont supérieures aux dimensions latérales du film 100, ce qui a pour conséquence que tout le film 100 est traité de manière simultanée, même si alternativement, le film 100 pourrait être traité par un faisceau étroit se déplaçant sur toute la surface à traiter.

Par ailleurs, le film 100 suit un mouvement de rotation régulière sur 360° pendant son traitement, de manière à ce que le traitement soit fait de manière homogène selon une symétrie de révolution. On comprend qu'alternativement, le faisceau 200 peut suivre un mouvement de rotation.

Ce protocole permet de délivrer des taux d'abrasion de 0,2 nm par seconde avec une horizontalité de l'ordre de 4,3 % sur des surfaces de 10 cm².

L'ouverture des premières couches 105 de pores et l'abrasion des murs de silice par faisceau d'ions permettent alors de conserver les molécules 120 greffées dans les pores ouverts, qualifiés d'alvéoles 115, si le faisceau 120 est appliqué en incidence rasante, par exemple environ 5° (Figure 3), du fait d'un phénomène d'ombrage créé par la combinaison de l'inclinaison du faisceau et de la présence de la cavité que constitue le pore. L'ombrage est causé par la masse de silice autour du pore. Cela est illustré en figure 3A, où le repère 116 montre la surface de l'alvéole 115 qui n'a pas été touchée par le faisceau 200 à l'instant où le traitement est stoppé.

La technique de réflectivité des rayons X est utilisée pour caractériser l'épaisseur des couches 105 à des échelles subnanométriques. Les courbes de la réflectivité mesurée avant et après gravure pendant 240 s sont présentées à la figure 6 (courbes 500 et 510 respectivement). Les mesures de réflectivité des rayons X ont été effectuées avec un réflectomètre Philips Xpert utilisant la radiation Kα d'une anode de Cobalt, de longueur d'onde 1,789 Å.

Les trois pics de Bragg indiqués par des flèches pour le film 100 gravé sont dus à la périodicité des couches de pores 105 dans la direction perpendiculaire au plan du substrat.

L'épaisseur finie du film 100 produit des franges de Kiessig tandis que la périodicité des couches 105 génère des réflexions de Bragg (situées à des valeurs de q_{z} de 0,067, 0,13 and 0,20 Å⁻¹ pour le film non gravé). L'analyse des franges de Kiessig montre que l'épaisseur a diminué de 101 nm à 65,8 nm après exposition du faisceau 200. Le film 100, initialement constitué de 11 couches 105 de pores voit ainsi son épaisseur réduite à 8 couches 105 après l'abrasion.

La position des pics de Bragg n'est que légèrement décalée après le traitement (à 0,075, 0,14 et 0,22 Å⁻¹ environ), ce qui montre que celui-ci n'a pas sensiblement modifié la périodicité des couches perpendiculairement à la surface. La position des pics de Bragg indique que l'épaisseur des couches 105 (figure 2 avant gravure, et figure 3 après gravure) est égale à 9.4 nm et 8.5 nm avant et après gravure respectivement. Cette faible différence est attribuée à une légère déformation de la forme sphérique des pores.

Ces deux caractéristiques sont cohérentes avec une diminution de l'épaisseur totale du film 100 due à l'élimination des premières couches 105 de silice sans destruction de la structure poreuse sous-jacente.

La topographie des surfaces a été observée par microscopie électronique à balayage (MEB) avec un microscope Hitachi 4100 / ZEISS utilisant un canon à effet de champ. La figure 7 présente un cliché MEB en vue de dessus d'un film mésoporeux 100 après enlèvement de matière. Elle montre la distribution des alvéoles 115 organisées selon un réseau cristallographique constitué de domaines d'orientations différentes, les domaines étant délimités par des frontières de domaines 160 représentées par des traits noirs ajoutés sur la photographie. La taille moyenne d'un domaine est d'environ 0,02 µm².

Selon un autre mode de réalisation, un champ magnétique intense peut être appliqué au moment de l'élaboration des couches 105, afin d'augmenter la taille de ces domaines jusqu'à obtenir une surface constituée d'un réseau monocristallin.

La figure 9 présente un cliché MEB en vue en coupe du film mésoporeux après la gravure (la coupe a été obtenue par fracture). A titre de comparaison, la figure 8 présente le même film, également vue en coupe avec la même technique, avant la gravure.

Les vues en coupe confirment la diminution d'épaisseur de 11 à 8 couches, précédemment démontrée par réflectivité (Figure 6).

Les clichés MEB confirment aussi que la symétrie lm3m, attendue pour ce film est telle que l'axe [110] de cette symétrie est perpendiculaire au plan de la surface.

Ces clichés montrent aussi que la légère déformation des pores 110 après gravure peut être attribuée à un écrasement de leur section circulaire de 8 à 6 nm le long de la direction normale au substrat.

En relation avec les figures 4 et 5, on utilise la surface nanostrustucturée du film mince 100 constituée d'alvéoles monodisperses 115, organisées selon un réseau cristallographique et possédant des fonctions 120 sélectivement présentes à la surface des alvéoles pour greffer des nanoparticules fonctionnelles 400.

La surface des pores 110 est greffée par des fonctions 120 cyanopropyles capables de former un complexe avec des nanoparticules 400 magnétiques de Fe-Pt (alliage fer-platine). Ces particules sphériques présentent un diamètre de 3 nm et sont solubles en solution aqueuse grâce à une couronne de ligands de cystéine (fonction thiol). Elles sont présentées dans un solvant 410 lors d'une étape d'imprégnation (figure 4).

Eventuellement, on tire avantage de la force capillaire 1200 se manifestant lors de l'évaporation du solvant 410. Cette force capillaire F_{c} qui commande la géométrie de la goutte de solvant au moment de l'évaporation (illustrée par l'angle de contact θ en figure 4) privilégie un dépôt des particules dans les alvéoles 115.

Par souci de clarté, il n'est représenté qu'une nanoparticule 400 greffée par alvéole 115 (figure 5).

La figure 11 montre des clichés MEB de la distribution de nanoparticules 400 adsorbées à la surface mésoporeuse ouverte et fonctionnalisée du film 100. A titre de comparaison, on a représenté en figure 10 une surface mésoporeuse ouverte non fonctionnalisée (en l'absence de fonctions 120).

Le procédé de localisation des nanoparticules 400 est considérablement amplifié si des fonctions 120 d'accrochage chimique complémentaires sont utilisées sur les alvéoles 115 et les particules 400, comme on l'a vu en figure 2.

Il apparait en effet d'après une inspection visuelle des clichés MEB que le nombre de nanoparticules 400 isolées dans des pores 110 fonctionnalisés est plus grand que le nombre de nanoparticules 400 adsorbées sur les surfaces entre les pores, qualifiées de murs de silice, et plus grand que le nombre de nanoparticules 400 présentes dans les pores 110 non fonctionnalisés.

Cette observation est confirmée par une approche statistique basée sur plus de 1500 pores 110, dont les résultats sont présentés en figure 12. On y a représenté un histogramme présentant le nombre de nanoparticules 400 de FePt présentes dans les alvéoles 115 d'un film 100 fonctionnalisé avec des fonctions 120 cyanoproyles (colonne 1110) et dans les alvéoles 110 d'un film 100 non fonctionnalisé (colonne 1120).

Les résultats montrent que le nombre de particules 400 dans les alvéoles 115 est 7 fois plus élevé pour le film 100 fonctionnalisé que pour le film 100 non fonctionnalisé. Concernant les particules 400 observées en dehors des alvéoles 115, le rapport est beaucoup plus faible (colonnes 1130 et 1140 respectivement), et c'est également le cas en ce qui concerne les particules 400 agrégées (colonnes 1150 et 1160 respectivement).

Selon ce mode de réalisation, le taux de remplissage des pores 110 est de l'ordre de 30 % pour le film 100 fonctionnalisé.

Cette démarche permet de localiser de manière contrôlée ces particules 400 dans des applications comme les matériaux à haute densité de stockage d'informations. Un tel réseau de particules 400 organisées sur une surface permet notamment d'orienter les spins par application d'un champ magnétique B, et d'atteindre sélectivement de manière contrôlée les particules avec une pointe de microscope à force magnétique (MFM).

Selon d'autres modes de réalisation, le taux de remplissage est plus élevé, du fait de la modification de la densité de fonctions chimiques greffées à la surface des pores 110, de la fonctionnalisation complémentaire des particules 400 et des pores 110, ou de l'ajustement du rapport des tailles des particules 400 et des alvéoles 115.

Selon un autre mode de réalisation représenté aux figures 1A à 1C, la mise en place d'un groupe d'accrochage à la surface des mésopores est réalisée par greffage post synthétique, les étapes de structuration de la couche mésoporeuse étant alors distinctes de l'étape de fonctionnalisation des pores et antérieures à celle-ci. On pourra pour cette étape se référer, si besoin, à la littérature, par exemple la revue A. Stein *et al.,* Advanced Materials, 12, 1403 (2000).

On commence par former le matériau mésoporeux 700 comprenant des pores 710, et on extrait les tensioactifs pour atteindre l'état représenté en figure 1A. On procède ensuite à l'imprégnation du matériau 700 avec une solution liquide 760 contenant des petites molécules capables de diffuser à travers la microporosité du matériau 700 (pores de diamètres inférieurs à 2 nm) (voir figure 1 B). Ces molécules sont choisies pour réagir avec la silice dans des conditions adaptées et après élimination du solvant 760, des groupes d'accrochage 720 sont présents à la surface de pores 710 (figure 1C identique à la figure 2).

Dans un autre mode de réalisation, on greffe des groupements par fonctionnalisation directe, puis on les modifie chimiquement et on y greffe des clusters (ou macromolécules) de manière post synthétique.

Selon un autre mode de réalisation, illustré aux figures 13 à 15, partant en figure 13 d'une structure similaire à celle présentée en figure 2 comportant des couches 1305 de pores, on ajuste les caractéristiques de l'abrasion (figure 14) pour former des surfaces nanostructurées laissant apparaître dans les fond des alvéoles 1150 le substrat 1301 sous jacent, sur lequel a été initialement déposé le matériau mésoporeux 1300.

On précise que quand le matériau mésoporeux est déposé ainsi sur un substrat, de nombreux pores 1310 sont ouverts sur le substrat (figure 13). Il ne reste donc à la fin du processus de gravure en figure 15 qu'une seule couche de pores, au moins certains pores formant des alvéoles 1150 étant à la fois ouverts vers l'extérieur (le haut en figure 15), constituant ainsi une surface nanostructurée 1500, et ouverts vers le substrat sous-jacent 1301 (le bas en figure 15). Il ne reste donc préférentiellement plus d'alvéoles fermées vers le bas par un fond en matériau mésoporeux, mais la surface nanostructurée est constituée d'une succession de murs de silice 1155 entre des surfaces d'affleurement 1306 du substrat 1301, par lesquels le substrat 1301 est accessible à travers les alvéoles 1150.

On tire alors avantage du fait que la gravure par faisceau d'ions 200 est uniforme jusqu'aux très faibles épaisseurs de couche, ce qui permet d'obtenir une surface 1500 nanostructurée très uniforme, les alvéoles 1150 étant très semblables les unes aux autres.

Des fonctions chimiques 1320 sont présentes dans certaines variantes dès la synthèse du matériau mésoporeux 1300, du fait d'une fonctionnalisation par synthèse directe au cours de l'élaboration des films de matériau 1310 (voir ci-dessus en relation avec la figure 2; et l'utilisation de précurseurs fonctionnalisés). Ces fonctions sont préférentiellement greffées spécifiquement dans les pores, à la surface de ceux-ci avec la tête fonctionnelle de la molécule dirigée vers le centre du pore, ou de l'alvéole 1150, une fois la porosité ouverte. Alternativement, elles ont pu être apportées par une fonctionnalisation post-synthétique du matériau mésoporeux (non représenté).

D'autres fonctions chimiques 1325 peuvent être ajoutées cette fois-ci sur la surface du substrat 1301 par une fonctionnalisation post synthétique, (figure 13).

Ainsi, à la fin de l'abrasion (figure 15), les surfaces d'affleurement 1306 du substrat 1301 sont porteuses de groupements fonctionnels 1325.

Dans un mode de réalisation particulier, les zones d'affleurement 1306 sont fonctionnalisées différemment de la surface des murs de silice 1155. Si la fonctionnalisation du matériau mésoporeux est faite de manière post-synthétique, on prend avantage pour cela de la nature chimique différente de ces deux surfaces en appliquant deux molécules différentes par imprégnation post synthétique, une molécule étant adaptée à réagir avec la silice, et l'autre avec la surface du substrat. Les groupes chimiques 1325 sont des groupements d'accrochage servant pour liaison ou complexation, comme une fonction nitrile.

Selon une variante également basée sur l'accessibilité des surfaces affleurantes du support à travers les pores, on forme ainsi des masques inorganiques pour la lithographie, ayant des tailles de motifs compris entre 2 et 50 nm (figures 21 à 24).

Partant d'un film mésoporeux 2300 comportant des couches 2305 dont les pores 2310 sont fonctionnalisés par des groupements d'accrochage 2320, et qui est placé sur un support 2301 (figure 21), on pratique une abrasion comme précédemment (figure 22) de manière à rendre des surfaces 2306 du substrat 2301 accessibles à travers les alvéoles 2315.

On met alors à profit les fonctions chimiques 2320 greffées à la surface des parois des pores 2310 pour ancrer des nanoparticules 2400, par exemple métalliques (figure 23). La coalescence de ces particules donne ainsi lieu à la formation d'anneaux (ou petits cylindres) de diamètre nanométrique contrôlé, et organisés les uns vis-à-vis des autres à la surface du support 2301.

Après élimination des murs de silice 2155 (figure 24), on obtient une assemblée d'anneaux 2500 constituant ainsi des masques et/ou des nanostructures originales.

En relation avec la figure 16, selon un autre mode de réalisation, des pores cylindriques de films mésoporeux en symétrie hexagonale p6m sont ouverts en surface. En effet, selon le type des tensioactifs utilisés et leur concentration introduite, il est possible de générer des pores 1610 de diverses géométrie, par exemple sphériques ou cylindriques. Par exemple, les couches 1605 de silices sont structurées par le tensioactif P123, permettant de former des pores cylindriques de diamètre 5 nm organisés en symétrie 2D hexagonale. Ainsi les nanoparticules peuvent être, outre des sphères, aussi des nanofils ou des nanotubes 1640, ancrés par un groupement d'accrochage 1620.

Les clichés MEB en vue de coupe présentés aux figures 17, 18 et 19 sont obtenus après des temps d'abrasion (gravure) de 50, 200 et 480 s. Ils révèlent la présence dé sillons 1700 alignés en surface, organisés comme des empreintes digitales.

La figure 20 montre que l'épaisseur gravée, telle qu'observée sur ces clichés, est linéairement proportionnelle au temps d'abrasion (gravure).

Pour le temps de gravure de 480 s, illustré en figure 19 le film nanostructuré n'a que 4 nm d'épaisseur. La gravure est uniforme jusqu'aux très faibles épaisseurs.

Selon d'autres modes de réalisation, l'alignement des pores est amélioré par l'utilisation de substrats disposant à l'avance d'un motif en relief, ou par l'application d'un champ magnétique intense au moment de l'élaboration des couches.

Selon un autre mode de réalisation, le procédé est mis en oeuvre pour greffer des nanoparticules de diamants dans des pores cylindriques. Le type de fonctionnalisation utilisé est alors des fonctions amines greffées à la surface des pores afin de former des liaisons peptidiques avec des groupements carboxyliques présents à la surface des particules. Les nanoparticules sont alignées dans les cylindres pour ensuite les utiliser comme réacteurs et former des nanofils de diamant.

Dans un mode de réalisation représenté aux figures 25 et 26, on effectue également une fonctionnalisation de la masse du film de silice 3100 par synthèse directe en plus de l'implantation d'un groupement d'accrochage 3120 dans les pores 3110. Des précurseurs fonctionnalisés de silice bi-silylés 3500 sont introduits dans la solution de synthèse du matériau mésoporeux. Ceux-ci peuvent comporter, entre deux extrémités silylées 3510, un ou plusieurs groupements fonctionnels 3520 qui peuvent être des groupements aryles, des métaux, et fonctions chimiques organiques, par exemple azotées ou oxygénées.

Ces molécules portant deux extrémités silylées 3510 effectuent une poly-condensation avec le reste du réseau de silice en portant les groupements fonctionnels 3520 au coeur des murs de silice. Ainsi le matériau comprend également une fonctionnalisation dans sa masse (figure 25).

Après abrasion (figure 26), ces groupements fonctionnels 3520 sont dans les murs de silice 3155 et sont utilisées pour effectuer des interactions physiques ou physico-chimiques avec des nano-objets 3400 positionnés dans les alvéoles 3115 grâce aux groupements d'accrochage 3120, éventuellement sur une distance de 5 à 25 Å ou plus. Des atomes du matériau constitutif des murs 3155 peuvent être présents dans l'espace intermédiaire entre le groupement fonctionnel 3520 et le nano-objet 3400.

Selon d'autres variantes, on effectue une multi-fonctionnalisation des pores par des fonctions différentes en différentes proportions.

Dans d'autres modes de réalisation, le matériau mésoporeux utilisé est, au lieu de la silice, un oxyde de titane, obtenu à l'aide d'un précurseur comme le tétra chlorure de titane (TiCl₄), ou le titanium isopropoxyde (Ti(OiPr)₄)

Dans d'autres modes de réalisation, les supports 101, 1300 ou 2300 sur lesquels le matériau mésoporeux est déposé sont constitués d'un matériau autre que le silicium, comme le verre ou l'or, ou un autre matériau présentant une affinité suffisante vis-à-vis du matériau mésoporeux pour avoir un dépôt homogène du film sur la surface du support. La surface de tout matériau support peut de plus être modifiée (notamment par un dépôt d'une couche intermédiaire, par un traitement chimique ou UV ozone, ...) pour améliorer cette affinité.

L'invention ne se limite pas aux modes de réalisation présentés, mais inclut les variantes à la portée de l'homme du métier telles que définies dans les revendications adjointes.

## Revendications

1. Procédé de préparation d'une surface structurée fonctionnelle comprenant une étape d'enlèvement contrôlé de matière appliquée à un matériau comprenant au moins un pore (110 ; 710 ; 1310 ; 1610 ; 2310 ; 3110) enterré dont la surface interne du pore comporte au moins un groupe chimique d'accrochage (120 ; 720 ; 1320 ; 1620 ; 2320 ; 3120), l'enlèvement de matière étant effectué par une technique d'abrasion anisotrope en sorte de rendre accessible une partie de la surface interne du pore non affectée par l'enlèvement de matière et de préserver le groupe chimique d'accrochage du fait d'un ombrage causé par la masse autour du pore.

2. Procédé selon la revendication 1 **caractérisé en ce qu'**il comporte de plus une étape de positionnement de nano-objets (400 ; 1640 ; 2400 ; 3400) sur la surface structurée.

3. Procédé selon la revendication 2 **caractérisé en ce que** ledit positionnement comprend une stabilisation par affinité chimique utilisant ledit groupe chimique d'accrochage (120 ; 720 ; 1320 ; 1620 ; 2320 ; 3120).

4. Procédé selon l'une des revendications 2 ou 3 **caractérisé en ce que** le positionnement comprend un dépôt par imprégnation.

5. Procédé selon l'une des revendications 1 à 4, **caractérisé en ce que** ledit matériau contient au moins une couche (105 ; 705 ; 1305 ; 1605 ; 2305) de pores, certaines au moins des surfaces internes respectives des pores comportant des groupes chimiques d'accrochage (120 ; 720 ; 1320 ; 1620 ; 2320 ; 3120), l'enlèvement de matière étant effectué avec des conditions de durée, intensité et direction choisies pour rendre accessibles des parties des surfaces internes respectives des pores non affectées par l'enlèvement de matière.

6. Procédé selon l'une des revendications 1 à 5 **caractérisé en ce que** l'enlèvement de matière est effectué par une application d'un faisceau (200) en incidence contrôlée.

7. Procédé selon la revendication 6 **caractérisé en ce que** ledit faisceau est un faisceau (200) d'ions argon.

8. Procédé selon l'une des revendications 1 à 7 **caractérisé en ce que** le matériau comprenant au moins un pore est préalablement formé à partir d'une solution liquide contenant un précurseur dudit matériau.

9. Procédé selon la revendication 8 **caractérisé en ce que** la solution comprend initialement un tensioactif (102).

10. Procédé selon la revendication 8 ou la revendication 9, **caractérisé en ce que** la solution contient des molécules capables de réagir avec le précurseur pour placer un groupe d'accrochage (120 ; 1320 ; 1620 ; 2320 ; 3120) à la surface des pores.

11. Procédé selon l'une des revendications 1 à 10 **caractérisé en ce qu'**il comprend une étape d'addition du ou au moins un groupe chimique d'accrochage (720 ; 1320 ; 1620 ; 2320 ; 3120) après une étape de formation du au moins un pore.

12. Procédé selon l'une des revendications 1 à 10 **caractérisé en ce que** le matériau comprend au moins un pore (110) sphérique.

13. Procédé selon l'une des revendications 1 à 11 **caractérisé en ce que** le matériau comprend au moins un pore (1610) cylindrique.

14. Procédé selon l'une des revendications 1 à 13 **caractérisé en ce que** l'étape d'enlèvement de matière est effectuée en sorte de rendre accessible à travers l'espace interne du pore une surface (1306 ; 2306) d'un support (1301 ; 2301) sur lequel ledit matériau est posé.

15. Procédé selon la revendication 14, **caractérisé en ce qu'**il comprend également une étape d'addition d'un groupe chimique d'accrochage sur ladite surface (1306) du support.

16. Procédé selon la revendication 14 ou la revendication 15, **caractérisé en ce qu'**il comprend également une étape d'élimination de restes (2155) du matériau comprenant au moins un pore après une étape de positionnement de nano-objets (2400) sur la surface structurée.

17. Procédé selon l'une des revendications 1 à 16 **caractérisé en ce que** le matériau comprenant au moins un pore est choisi parmi les oxydes de silicium, titane, zinc ou aluminium.

18. Procédé selon l'une des revendications 1 à 17 **caractérisé en ce que** le groupe chimique d'accrochage (120 ; 1320 ; 1620 ; 2320 ; 3120) comprend une fonction nitrile.

19. Procédé selon l'une des revendications 1 à 17 **caractérisé en ce que** le matériau comprenant au moins un pore comprend également des groupes chimiques capables d'échanger des charges (3520) dans sa masse.

## Patentansprüche

1. Verfahren zur Herstellung einer strukturierten Funktionsoberfläche, umfassend einen Schritt zum kontrollierten Materialabtragen, der auf ein Material angewandt wird, das wenigstens eine verdeckt liegende Pore (110; 710; 1310; 1610; 2310; 3110) aufweist, deren Poreninnenfläche wenigstens eine chemische Haftgruppe (120; 720; 1320; 1620; 2320; 3120) umfasst, wobei der Materialabtrag mittels einer anisotropen Abrasionstechnik vollzogen wird, so dass ein Teil der Innenfläche der Pore, der nicht von dem Materialabtrag betroffen ist, zugänglich gemacht und die chemische Haftgruppe aufgrund eines durch die Masse um die Pore herum bewirkten Beschattens bewahrt wird.

2. Verfahren nach Anspruch 1, **dadurch gekennzeichnet, dass** es zudem einen Schritt zur Positionierung von Nanoobjekten (400; 1640; 2400; 3400) auf der strukturierten Oberfläche umfasst.

3. Verfahren nach Anspruch 2, **dadurch gekennzeichnet, dass** das Positionieren eine Stabilisierung mittels chemischer Affinität, die die chemische Haftgruppe (120; 720; 1320; 1620; 2320; 3120) verwendet, umfasst.

4. Verfahren nach einem der Ansprüche 2 oder 3, **dadurch gekennzeichnet, dass** das Positionieren ein Abscheiden durch Imprägnieren umfasst.

5. Verfahren nach einem der Ansprüche 1 bis 4, **dadurch gekennzeichnet, dass** das Material wenigstens eine Porenschicht (105; 705; 1305; 1605; 2305) umfasst, wobei wenigstens einige der jeweiligen Innenflächen der Poren chemische Haftgruppen (120; 720; 1320; 1620; 2320; 3120) umfassen, wobei der Materialabtrag mit Dauer-, Intensitäts- und Richtungsbedingungen erfolgt, die gewählt sind, um Teile der jeweiligen Innenflächen der Poren, die nicht von dem Materialabtrag betroffen sind, zugänglich zu machen.

6. Verfahren nach einem der Ansprüche 1 bis 5, **dadurch gekennzeichnet, dass** der Materialabtrag durch ein Anlegen eines Strahlenbündels (200) unter kontrolliertem Einfallswinkel vollzogen wird.

7. Verfahren nach Anspruch 6, **dadurch gekennzeichnet, dass** das Strahlenbündel ein Argonionen-Strahlenbündel (200) ist.

8. Verfahren nach einem der Ansprüche 1 bis 7, **dadurch gekennzeichnet, dass** das wenigstens eine Pore umfassende Material zuvor aus einer einen Vorläufer des Materials umfassenden flüssigen Lösung gebildet wird.

9. Verfahren nach Anspruch 8, **dadurch gekennzeichnet, dass** die Lösung anfangs ein Tensid (102) umfasst.

10. Verfahren nach Anspruch 8 oder Anspruch 9, **dadurch gekennzeichnet, dass** die Lösung Moleküle enthält, die in der Lage sind, mit dem Vorläufer zu reagieren, um eine Haftgruppe (120; 1320; 1620; 2320; 3120) an der Oberfläche der Poren zu platzieren.

11. Verfahren nach einem der Ansprüche 1 bis 10, **dadurch gekennzeichnet, dass** es einen Schritt zur Zugabe der oder wenigstens einer chemischen Haftgruppe (720; 1320; 1620; 2320; 3120) nach einem Schritt zur Bildung der wenigstens einen Pore umfasst.

12. Verfahren nach einem der Ansprüche 1 bis 10, **dadurch gekennzeichnet, dass** das Material wenigstens eine kugelförmige Pore (110) umfasst.

13. Verfahren nach einem der Ansprüche 1 bis 11, **dadurch gekennzeichnet, dass** das Material wenigstens eine zylindrische Pore (1610) umfasst.

14. Verfahren nach einem der Ansprüche 1 bis 13, **dadurch gekennzeichnet, dass** der Schritt des Materialabtragens durchgeführt wird, so dass durch den Innenraum der Pore eine Oberfläche (1306; 2306) eines Trägers (1301; 2301), auf den das Material aufgebracht ist, zugänglich gemacht wird.

15. Verfahren nach Anspruch 14, **dadurch gekennzeichnet, dass** es auch einen Schritt zur Zugabe einer chemischen Haftgruppe auf die Oberfläche (1306) des Trägers umfasst.

16. Verfahren nach Anspruch 14 oder Anspruch 15, **dadurch gekennzeichnet, dass** es auch einen Schritt zum Entfernen von Resten (2155) des wenigstens eine Pore umfassenden Materials nach einem Schritt zur Positionierung von Nanoobjekten (2400) auf der strukturierten Oberfläche umfasst.

17. Verfahren nach einem der Ansprüche 1 bis 16, **dadurch gekennzeichnet, dass** das wenigstens eine Pore umfassende Material aus den Silizium-, Titan-, Zink- oder Aluminiumoxiden ausgewählt ist.

18. Verfahren nach einem der Ansprüche 1 bis 17, **dadurch gekennzeichnet, dass** die chemische Haftgruppe (120; 1320; 1620; 2320; 3120) eine Nitrilfunktion umfasst.

19. Verfahren nach einem der Ansprüche 1 bis 17, **dadurch gekennzeichnet, dass** das wenigstens eine Pore umfassende Material auch chemische Gruppen umfasst, die in der Lage sind, in seiner Masse Ladungen (3520) auszutauschen.

## Claims

1. Method for preparing a functional structured surface comprising a step of controlled removal of material applied to a material comprising at least one buried pore (110; 710; 1310; 1610; 2310; 3110) wherein the internal surface of the pore comprises at least one chemical anchoring group (120; 720; 1320; 1620; 2320; 3120), the removal of material being carried out by a technique of anisotropic abrasion in such a way that a portion of the internal surface of the pore, unaffected by the removal of material is rendered accessible and the chemical anchoring group is preserved on account of shading caused by the mass around the pore.

2. Method according to claim 1, **characterized in that** it further comprises a step of positioning of nano-objects (400; 1640; 2400; 3400) on the structured surface.

3. Method according to claim 2, **characterized in that** said positioning comprises a stabilization by chemical affinity employing said chemical anchoring group (120; 720; 1320; 1620; 2320; 3120).

4. Method according to one of claims 2 or 3, **characterized in that** the positioning comprises deposition by impregnation.

5. Method according to one of claims 1 to 4, **characterized in that** said material contains at least one layer (105; 705; 1305; 1605; 2305) of pores, at least some of the respective internal surfaces of the pores comprising chemical anchoring groups (120; 720; 1320; 1620; 2320; 3120), the removal of material being carried out with conditions of duration, intensity and direction selected so that portions of the respective internal surfaces of the pores, unaffected by the removal of material, are rendered accessible.

6. Method according to one of claims 1 to 5, **characterized in that** the removal of material is carried out by application of a beam (200) with controlled incidence.

7. Method according to claim 6, **characterized in that** said beam is a beam (200) of argon ions.

8. Method according to one of claims 1 to 7, **characterized in that** the material comprising at least one pore is formed beforehand from a liquid solution containing a precursor of said material.

9. Method according to claim 8, **characterized in that** the solution initially comprises a surfactant (102).

10. Method according to claim 8 or claim 9, **characterized in that** the solution contains molecules capable of reacting with the precursor for placement of an anchoring group (120; 1320; 1620; 2320; 3120) on the surface of the pores.

11. Method according to one of claims 1 to 10, **characterized in that** it comprises a step of addition of or at least one chemical anchoring group (720; 1320; 1620; 2320; 3120) after a step of formation of the at least one pore.

12. Method according to one of claims 1 to 10, **characterized in that** the material comprises at least one spherical pore (110).

13. Method according to one of claims 1 to 11, **characterized in that** the material comprises at least one cylindrical pore (1610).

14. Method according to one of claims 1 to 13, **characterized in that** the material removal step is carried out so as to render accessible, via the internal space of the pore, a surface (1306; 2306) of a support (1301; 2301) on which said material is placed.

15. Method according to claim 14, **characterized in that** it also comprises a step of addition of a chemical anchoring group on said surface (1306) of the support.

16. Method according to claim 14 or claim 15, **characterized in that** it further comprises a step of removal of residues (2155) of the material comprising at least one pore after a step of positioning of nano-objects (2400) on the structured surface.

17. Method according to one of claims 1 to 16, **characterized in that** the material comprising at least one pore is selected from oxides of silicon, titanium, zinc or aluminium.

18. Method according to one of claims 1 to 17, **characterized in that** the chemical anchoring group (120; 1320; 1620; 2320; 3120) comprises a nitrile function.

19. Method according to one of claims 1 to 17, **characterized in that** the material comprising at least one pore also comprises chemical groups capable of exchanging charges (3520) in its bulk.
